# EUROPEAN PATENT APPLICATION

(11) **EP 4 644 931 A1**
(43) Date of publication of application: **05.11.2025**
(21) Application number: 23909011.1
(22) Date of filing: 09.06.2023
(51) Int. Cl.: G01R 31/392

(54) **METHOD FOR CALCULATING STATE-OF-HEALTH VALUE OF BATTERY, STORAGE MEDIUM, SERVER, AND VEHICLE**

(30) Priority: 29.12.2022 CN 202211704412
(71) Applicant: BYD Company Limited, Shenzhen, Guangdong 518118 (CN)
(72) Inventor: SHU, Shiwei, Shenzhen, Guangdong 518118 (CN); FENG, Tianyu, Shenzhen, Guangdong 518118 (CN); DENG, Linwang, Shenzhen, Guangdong 518118 (CN)
(74) Representative: Mathys & Squire
(86) International application number: PCT/CN2023/099353
(87) International publication number: WO 2024/139065

(57) **Abstract**

A method for calculating a state-of-health value of a battery, a storage medium, a server, and a vehicle. The method for calculating a state-of-health value of a battery includes: acquiring factory data of a battery as delivered from a factory, and acquiring a capacity value corresponding to a high voltage inflection point of a first charging V-Q curve of the battery as delivered from the factory; acquiring an open-circuit voltage value corresponding to an OCV-SOC curve corresponding to the battery in a voltage plateau region; acquiring charging data of the battery in an actual charging process after delivery from the factory; determining, according to the charging data, a corresponding plateau voltage value when the battery is in the voltage plateau region; and calculating a state-of-health value of the battery according to the factory data, the capacity value, the open-circuit voltage value, the charging data and/or the plateau voltage value.

## Description

### CROSS-REFERENCE TO RELATED APPLICATIONS

The present disclosure claims priority of the Chinese Patent Application No. 202211704412.4 filed to the China National Intellectual Property Administration on December 29, 2022, entitled "METHOD FOR CALCULATING STATE-OF-HEALTH VALUE OF BATTERY, STORAGE MEDIUM, SERVER, AND VEHICLE", which is incorporated herein by reference in its entirety.

### FIELD

The present disclosure relates to the technical field of batteries, in particular to a method for calculating a state-of-health value of a battery, a storage medium, a server and a vehicle.

### BACKGROUND

With the development of technology, the lithium-ion battery market has reached a historical high. This historical high is driven by strong demand for new renewable energy solutions, such as electric vehicles, electric planes and electric ships, and the batteries in these systems will face more severe operating conditions, such as higher power and energy demands, than other applications. However, these demands all have an accelerating effect on battery aging, and the accelerated aging of the battery is a significant threat to the safety and stability of electric products. Therefore, it is necessary to track the health of a battery, such as SOHC (capacity fade rate) and SOHR (internal resistance aging rate), and determine when to terminate its service life during actual use.

### SUMMARY

The present disclosure is intended to at least resolve one of technical problems in the related art. Accordingly, one object of the present disclosure is to provide a method for calculating a state-of-health value of a battery, and the method can realize the monitoring of the state-of-health of the battery in the whole life cycle and improve the calculation accuracy of the state-of-health of the battery.

A second object of the present disclosure is to provide a computer storage medium.

A third object of the present disclosure is to provide a server.

A fourth object of the present disclosure is to provide a vehicle.

To solve the above problem, the first aspect of the present disclosure provides a method for calculating a state-of-health value of a battery including: factory data of a battery as delivered from a factory is acquired, and a capacity value corresponding to a high voltage inflection point of a first charging V-Q curve of the battery as delivered from the factory is acquired; an open-circuit voltage value corresponding to a voltage plateau region of an OCV-SOC curve corresponding to the battery is acquired; charging data of the battery in an actual charging process after delivery from the factory is acquired; a plateau voltage value corresponding to the voltage plateau region of the battery is determined according to the charging data; and the state-of-health value of the battery is calculated according to the factory data, the capacity value, the open-circuit voltage value, the charging data and/or the plateau voltage value.

According to the method for calculating the state-of-health value of the battery provided by the embodiment of the present disclosure, the state-of-health value of the battery can be calculated according to the charging data in the actual charging process of the battery and the factory data, the capacity value, the open-circuit voltage value and the plateau voltage value of the battery without deep discharging of the battery, the monitoring of the state-of-health of the battery in the whole life cycle is realized, the SOC value of the battery is not needed in the process, the problem of excessive dependence on the SOC estimation accuracy of the battery is effectively avoided, the calculation accuracy of the state-of-health of the battery is effectively improved, and the calculation method is simple and easy to implement.

In some embodiments, that an open-circuit voltage value corresponding to a voltage plateau region of an OCV-SOC curve corresponding to the battery is acquired includes: a first open-circuit voltage value corresponding to a low voltage plateau region of the OCV-SOC curve corresponding to the battery is acquired; a second open-circuit voltage value corresponding to a medium voltage plateau region of the OCV-SOC curve corresponding to the battery is acquired; and a third open-circuit voltage value corresponding to a high voltage plateau region of the OCV-SOC curve corresponding to the battery is acquired.

In some embodiments, at least two voltage plateau regions are provided, and the plateau voltage values include at least two of a low plateau voltage value, a medium plateau voltage value and a high plateau voltage value. That a plateau voltage value corresponding to the voltage plateau region of the battery is determined according to the charging data includes: a second charging V-Q curve of the battery is generated according to the charging data; a differential processing is performed on the second charging V-Q curve to acquire a dQ/dV-V curve corresponding to the battery; an actual voltage value corresponding to each voltage plateau region of the battery is acquired according to the dQ/dV-V curve; and the low plateau voltage value, the medium plateau voltage value and/or the high plateau voltage value of the battery are determined according to the actual voltage value corresponding to each voltage plateau region.

In some embodiments, two voltage plateau regions are provided. That an actual voltage value corresponding to each voltage plateau region of the battery is acquired according to the dQ/dV-V curve includes: a first actual voltage value and a second actual voltage value respectively corresponding to the two voltage plateau regions of the battery are acquired according to the dQ/dV-V curve.

That the low plateau voltage value, the medium plateau voltage value and/or the high plateau voltage value of the battery are determined according to the actual voltage value corresponding to each voltage plateau region includes: a voltage difference value between the first actual voltage value and the second actual voltage value is calculated; if it is determined that the voltage difference value is in a first preset voltage range, the minimum voltage value of the first actual voltage value and the second actual voltage value is taken as the low plateau voltage value, and the maximum voltage value of the first actual voltage value and the second actual voltage value is taken as the medium plateau voltage value; if it is determined that the voltage difference value is in a second preset voltage range, the minimum voltage value of the first actual voltage value and the second actual voltage value is taken as the medium plateau voltage value, and the maximum voltage value of the first actual voltage value and the second actual voltage value is taken as the high plateau voltage value; an upper limit value of the second preset voltage range is a lower limit value of the first preset voltage range.

In some embodiments, the factory data includes a factory resistance value, the state-of-health value includes an SOHR value of the battery, the voltage plateau regions include the low voltage plateau region and the medium voltage plateau region, and the charging data includes a charging current of the battery. That the state-of-health value of the battery is calculated according to the factory data, the capacity value, the open-circuit voltage value, the charging data and/or the plateau voltage value includes: a first direct current resistance value corresponding to the low voltage plateau region of the battery is calculated according to the first open-circuit voltage value, the charging current and the low plateau voltage value; a second direct current resistance value corresponding to the medium voltage plateau region of the battery is calculated according to the second open-circuit voltage value, the charging current and the medium plateau voltage value; an actual resistance value of the battery is calculated according to the first direct current resistance value and the second direct current resistance value; and the SOHR value of the battery is calculated according to the factory resistance value and the actual resistance value.

In some embodiments, the factory data includes the factory resistance value, the state-of-health value includes the SOHR value of the battery, the voltage plateau regions include the medium voltage plateau region and the high voltage plateau region, and the charging data includes the charging current of the battery. That the state-of-health value of the battery is calculated according to the factory data, the capacity value, the open-circuit voltage value, the charging data and/or the plateau voltage value includes: the second direct current resistance value corresponding to the medium voltage plateau region of the battery is calculated according to the second open-circuit voltage value, the charging current and the medium plateau voltage value; a third direct current resistance value corresponding to the high voltage plateau region of the battery is calculated according to the third open-circuit voltage value, the charging current and the high plateau voltage value; the actual resistance value of the battery is calculated according to the second direct current resistance value and the third direct current resistance value; and the SOHR value of the battery is calculated according to the factory resistance value and the actual resistance value.

In some embodiments, three voltage plateau regions are provided. That an actual voltage value corresponding to each voltage plateau region of the battery is acquired according to the dQ/dV-V curve includes: a first actual voltage value, a second actual voltage value and a third actual voltage value respectively corresponding to the three voltage plateau regions of the battery are acquired according to the dQ/dV-V curve. That the low plateau voltage value, the medium plateau voltage value and/or the high plateau voltage value of the battery are determined according to the actual voltage value corresponding to each voltage plateau region includes: the minimum voltage value among the first actual voltage value, the second actual voltage value and the third actual voltage value is taken as the low plateau voltage value; the maximum voltage value among the first actual voltage value, the second actual voltage value and the third actual voltage value is taken as the high plateau voltage value; the voltage value other than the minimum voltage value and the maximum voltage value among the first actual voltage value, the second actual voltage value, and the third actual voltage value is taken as the medium plateau voltage value.

In some embodiments, the factory data includes the factory resistance value, the state-of-health value includes the SOHR value of the battery, the voltage plateau regions include the low voltage plateau region, the medium voltage plateau region and the high voltage plateau region, and the charging data includes the charging current of the battery. That the state-of-health value of the battery is calculated according to the factory data, the capacity value, the open-circuit voltage value, the charging data and/or the plateau voltage value includes: the first direct current resistance value corresponding to the low voltage plateau region of the battery is calculated according to the first open-circuit voltage value, the charging current and the low plateau voltage value; the second direct current resistance value corresponding to the medium voltage plateau region of the battery is calculated according to the second open-circuit voltage value, the charging current and the medium plateau voltage value; the third direct current resistance value corresponding to the high voltage plateau region of the battery is calculated according to the third open-circuit voltage value, the charging current and the high plateau voltage value; the actual resistance value of the battery is calculated according to the first direct current resistance value, the second direct current resistance value and the third direct current resistance value; and the SOHR value of the battery is calculated according to the factory resistance value and the actual resistance value.

In some embodiments, before the differential processing is performed on the second charging V-Q curve, the method for calculating the state-of-health value of the battery further includes: a smoothing filtering processing is performed on the second charging V-Q curve.

In some embodiments, the factory data includes a factory capacity value, and the state-of-health value includes an SOHC value of the battery. That the state-of-health value of the battery is calculated according to the factory data, the capacity value, the open-circuit voltage value, the charging data and/or the plateau voltage value includes: the second charging V-Q curve of the battery is generated according to the charging data; the differential processing is performed on the second charging V-Q curve to acquire a dV/dQ-Q curve corresponding to the battery; a capacity difference value between a capacity value at a high voltage inflection point and a capacity value at a full charging point of the battery on the dV/dQ-Q curve is acquired; an actual capacity value of the battery is acquired according to the capacity difference value and the capacity value; and the SOHC value of the battery is calculated according to the actual capacity value and the factory capacity value.

In some embodiments, that factory data of a battery as delivered from a factory is acquired includes: an ambient temperature of the battery is acquired; and the factory data of the battery is determined according to the ambient temperature.

The second aspect of the present disclosure provides a computer storage medium, storing a computer program which, when executed by a processor, causes the processor to implement the method for calculating the state-of-health value of the battery according to the embodiments.

The third aspect of the present disclosure provides a server including: at least one first processor; and a first memory communicatively connected with the at least one first processor, the first memory storing a computer program executable by the at least one first processor, and when executing the computer program, the at least one first processor implementing the method for calculating the state-of-health value of the battery according to the embodiments.

The server according to the embodiments of the present disclosure can realize the monitoring of the state-of-health of the battery in the whole life cycle and improve the calculation accuracy of the state-of-health of the battery by implementing the method for calculating the state-of-health value of the battery provided in the embodiments.

In some embodiments, the server periodically receives the charging data in the charging process of the battery.

The fourth aspect of the present disclosure provides a vehicle including: at least one second processor; and a second memory communicatively connected with the at least one second processor, the second memory storing a computer program executable by the at least one second processor, and when executing the computer program, the at least one second processor implementing the method for calculating the state-of-health value of the battery according to the embodiments.

The vehicle according to the embodiments of the present disclosure can realize the monitoring of the state-of-health of the battery in the whole life cycle and improve the calculation accuracy of the state-of-health of the battery by implementing the method for calculating the state-of-health value of the battery provided in the embodiments.

Additional aspects and advantages of the present disclosure will be set forth in part in the following description, or can be obvious from the following description, or can be learned through practice of the present disclosure.

### BRIEF DESCRIPTION OF THE DRAWINGS

The above and/or additional aspects and advantages of the present disclosure will become apparent and easily understood from the description of the embodiments in conjunction with the accompanying drawings below
FIG. 1 is a flow chart of a method for calculating a state-of-health value of a battery according to an embodiment of the present disclosure;
FIG. 2 is a schematic diagram of a second charging V-Q curve according to an embodiment of the present disclosure;
FIG. 3 is a schematic diagram of a dQ/dV-V curve according to an embodiment of the present disclosure;
FIG. 4 is a schematic diagram of a dV/dQ-Q curve according to an embodiment of the present disclosure;
FIG. 5 is a structural block diagram of a server according to an embodiment of the present disclosure;
FIG. 6 is a structural block diagram of a vehicle according to an embodiment of the present disclosure.

### DETAILED DESCRIPTION

The embodiments described with reference to the drawings are exemplary, and the embodiments of the present disclosure are described in detail below.

In the related art, for a state-of-health of a battery, such as a capacity fade rate SOHC, total electric quantity in a charging or discharging stage is calculated by fully charging and discharging the battery, or charging and discharging the battery in a certain SOC (State of Charge) interval, and the total battery capacity is calculated according to the charging or discharging electric quantity and the corresponding SOC interval. However, the estimation accuracy of the above manner completely depends on the accuracy of the SOC. If the estimation error of the SOC is large, the error accumulation of the SOC affects the accuracy of the SOHC, and the error of the SOHC in turn affects the accuracy of the SOC, cross effects are formed, and finally the estimation of the SOHC is completely invalid. The internal resistance aging rate SOHR is mainly estimated by online wavelet analysis and Kalman filtering for battery internal resistance, but this manner requires high-frequency sampling signals, has extremely high requirements on hardware, and has a large computational load and consumes time and energy.

To solve the above problem, the first aspect of the present disclosure provides a method for calculating a state-of-health value of a battery. The method can realize the monitoring of the state-of-health of the battery in the whole life cycle and improve the calculation accuracy of the state-of-health of the battery.

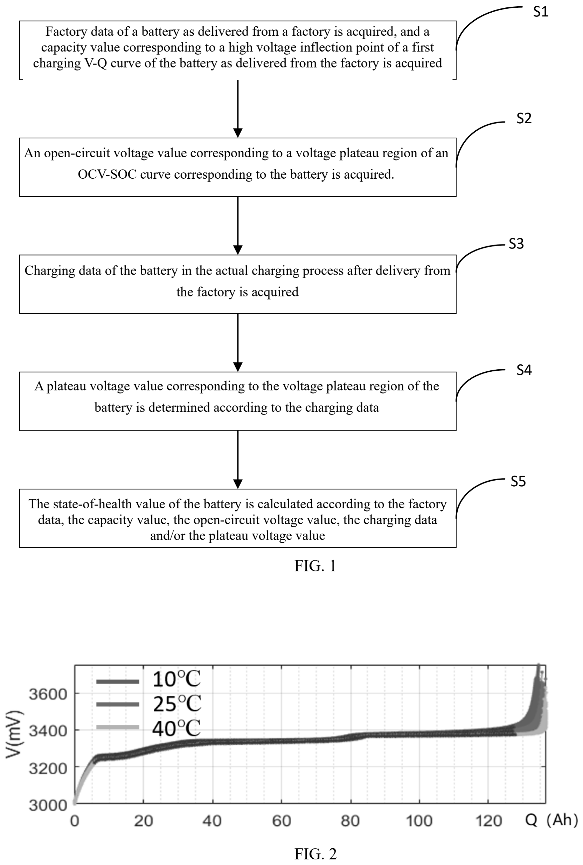

The method for calculating the state-of-health value of the battery according to the embodiment of the present disclosure is described below with reference to FIG. 1. As shown in FIG. 1, the method includes at least steps S1-S5.

Step S1. Factory data of a battery as delivered from a factory is acquired, and a capacity value corresponding to a high voltage inflection point of a first charging V-Q curve of the battery as delivered from the factory is acquired.

The factory data can be understood as data of the battery when the battery is delivered from a factory, that is to say, when the battery is not involved in any actual application, such as factory capacity value and factory resistance value. It can be understood that after the battery is delivered from a factory, the factory data of the battery changes with the actual use environment and use time, for example, the factory capacity value gradually decreases and the factory resistance value gradually increases with battery aging.

In an embodiment, after the battery is manufactured, the battery is tested at the factory, and the factory data of the battery is recorded and stored. In addition, the first charging V-Q curve of the battery in the charging process at the factory test is recorded, and the capacity value corresponding to the high voltage inflection point of the curve is calibrated offline by analyzing the voltage characteristics of the curve and denoted as Q_{HVTP}, so as to retrieve and use the capacity value when the state-of-health of the battery is monitored during subsequent use of the battery.

In some embodiments, considering that the factory data of the battery changes with the different environments, and is particularly greatly affected by the ambient temperature, when the factory data of the battery is acquired, the ambient temperature of the battery in the actual charging process is acquired first, and the factory data of the battery is determined according to the ambient temperature. That is to say, different factory data of the battery correspond to different ambient temperatures, for example, a set of factory data corresponds to 25°C, and another set of factory data corresponds to 30°C, the factory data is queried according to the ambient temperature, and the calculation accuracy of the state-of-health of the battery can effectively avoid being affected by the problem of ambient temperature when the state-of-health value of the battery is calculated subsequently.

Step S2. An open-circuit voltage value corresponding to a voltage plateau region of an OCV-SOC curve corresponding to the battery is acquired.

The voltage plateau region refers to a region where the voltage of the battery changes extremely slowly during the charging process. The open-circuit voltage value refers to the terminal voltage of the battery in an open-circuit state.

Step S3. Charging data of the battery in the actual charging process after delivery from the factory is acquired. That is to say, after actual application, when the battery is charged, the charging data of the battery, such as voltage, capacity and current, is acquired and stored in real time, so as to retrieve and use the charging data when the state-of-health of the battery is monitored during subsequent use of the battery.

Step S4. A plateau voltage value corresponding to the voltage plateau region of the battery is determined according to the charging data. The plateau voltage value refers to the terminal voltage of the battery in the voltage plateau region under the charging state.

Step S5. The state-of-health value of the battery is calculated according to the factory data, the capacity value, the open-circuit voltage value, the charging data and/or the plateau voltage value.

In the embodiment, by utilizing the characteristic that a capacity difference value between the capacity value corresponding to the high voltage inflection point and the capacity value corresponding to the completely discharged state (SOC=0) on the first charging V-Q curve remains unchanged with battery aging, according to the factory data, the capacity value and the open-circuit voltage value, the state-of-health value of the battery can be calculated only by the charging data and the plateau voltage value acquired in the charging process of the battery, so as to realize the monitoring of the state-of-health of the battery in the whole life cycle. In the calculation process, the battery does not need to be deeply discharged, the SOC state of the battery at the beginning of charging does not need to be determined, the SOC absolute value is not involved, and complex algorithms such as wavelet analysis and Kalman filtering are not needed, the problem that the calculation accuracy of the state-of-health value is affected by inaccurate estimation of the SOC state of the battery can be effectively avoided, the calculation efficiency and accuracy of the state-of-health value of the battery are improved, the test cost for estimating the state-of-health value of the battery is effectively reduced, and the calculation method is simple and easy to implement.

According to the method for calculating the state-of-health value of the battery of the embodiment of the present disclosure, the state-of-health value of the battery can be calculated according to the charging data in the actual charging process of the battery and the factory data, the capacity value, the open-circuit voltage value and the plateau voltage value of the battery without deep discharging the battery, so as to realize the monitoring of the state-of-health of the battery in the whole life cycle. In the process, the SOC value of the battery is not needed, the problem of excessive dependence on the estimation accuracy of the SOC of the battery is effectively avoided, the calculation accuracy of the state-of-health of the battery is effectively improved, and the calculation method is simple and easy to implement.

In some embodiments, the V-Q curve of the battery can have three regions where the voltage of the battery changes extremely slowly, which are divided into a low voltage plateau region, a medium voltage plateau region and a high voltage plateau region according to the charging voltage. A region with a faster voltage change is between two voltage plateau regions. The point with the fastest voltage change in the region is referred to as a voltage inflection point. In the two voltage inflection points, the inflection point with a higher voltage is referred to as the high voltage inflection point (denoted as HVTP), and the inflection point with a lower voltage is referred to as the low voltage inflection point (denoted as LVTP). According to the above, when acquiring the open-circuit voltage value corresponding to the voltage plateau region of the OCV-SOC curve corresponding to the battery, it is necessary to acquire a first open-circuit voltage value corresponding to the low voltage plateau region of the OCV-SOC curve corresponding to the battery, a second open-circuit voltage value corresponding to the medium voltage plateau region of the OCV-SOC curve corresponding to the battery, and a third open-circuit voltage value corresponding to the high voltage plateau region of the OCV-SOC curve corresponding to the battery.

In some embodiments, at least two voltage plateau regions are provided, and the plateau voltage values include at least two of a low plateau voltage value, a medium plateau voltage value and a high plateau voltage value. Specifically, in the actual charging process of the battery, due to the actual conditions such as the charging time of the battery, one voltage plateau region, two voltage plateau regions or three voltage plateau regions may be present. Therefore, when determining the plateau voltage value, the low plateau voltage value, the medium plateau voltage value and the high plateau voltage value can be determined according to the actual condition of the voltage plateau region in this charging. For example, when the voltage plateau regions include the low voltage plateau region and the medium voltage plateau region, the low plateau voltage value and the medium plateau voltage value need to be determined; when the voltage plateau regions include the medium voltage plateau region and the high voltage plateau region, the medium plateau voltage value and the high plateau voltage value need to be determined; and when the voltage plateau regions include the low voltage plateau region, the medium voltage plateau region and the high voltage plateau region, the low plateau voltage value, the medium plateau voltage value and the high plateau voltage value need to be determined.

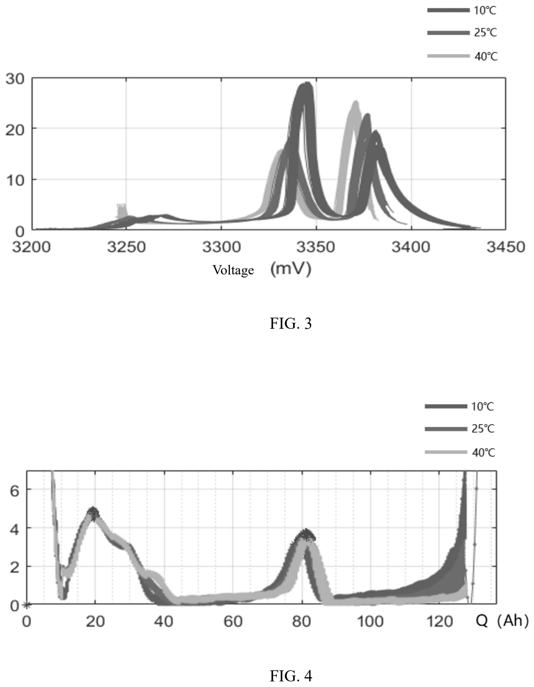

That a plateau voltage value corresponding to the voltage plateau region of the battery is determined according to the charging data includes: generating a second charging V-Q curve of the battery according to the charging data (such as the charging voltage) and the real-time capacity value of the battery in the charging process, as shown in FIG. 2; performing a differential processing on the second charging V-Q curve to acquire a dQ/dV-V curve corresponding to the battery, as shown in FIG. 3; acquiring an actual voltage value corresponding to each voltage plateau region of the battery according to the dQ/dV-V curve. However, when the battery is charging, the low voltage plateau region and the medium voltage plateau region may be present, or the medium voltage plateau region and the high voltage plateau region may be present, or the low voltage plateau region, the medium voltage plateau region and the high voltage plateau region may be present, and it is impossible to determine the plateau voltage value of which voltage plateau region the acquired actual voltage values correspond to. Therefore, the low plateau voltage value, the medium plateau voltage value and/or the high plateau voltage value of the battery need to be determined according to the actual voltage value corresponding to each voltage plateau region. The low plateau voltage value is the voltage value of the battery in the low voltage plateau region, the medium plateau voltage value is the voltage value of the battery in the medium voltage plateau region, and the high plateau voltage value is the voltage value of the battery in the high voltage plateau region.

In some embodiments, before the differential processing is performed on the second charging V-Q curve, a smoothing filtering processing is performed on the second charging V-Q curve.

It can be understood that the second charging V-Q curve is formed during the actual use of the battery after delivery from the factory, and is drawn by using the charging data of the battery after the actual alternating current charging begins. The curve changes due to the gradual aging of the battery, and is different from the first charging V-Q curve.

In some embodiments, two voltage plateau regions are provided, and a first actual voltage value and a second actual voltage value respectively corresponding to the two voltage plateau regions of the battery are acquired according to the dQ/dV-V curve. That is to say, the dQ/dV-V curve formed in the charging process has two regions where the voltage of the battery changes extremely slowly, and in each region, the acquired actual voltage values are the first actual voltage value and the second actual voltage value respectively.

In order to specifically distinguish the plateau voltage value of which voltage plateau region the first actual voltage value and the second actual voltage value correspond to respectively, In the present disclosure, the voltage difference value between the first actual voltage value and the second actual voltage value is calculated, and the plateau voltage value is determined according to the voltage difference value.

Specifically, if it is determined that the voltage difference value is in a first preset voltage range, the minimum voltage value of the first actual voltage value and the second actual voltage value is taken as the low plateau voltage value, and the maximum voltage value of the first actual voltage value and the second actual voltage value is taken as the medium plateau voltage value. For example, if the first actual voltage value is greater than the second actual voltage value, the first actual voltage value is the medium plateau voltage value, and the second actual voltage value is the low plateau voltage value; and if the first actual voltage value is less than the second actual voltage value, the second actual voltage value is the medium plateau voltage value, and the first actual voltage value is the low plateau voltage value.

If it is determined that the voltage difference value is in a second preset voltage range, the minimum voltage value of the first actual voltage value and the second actual voltage value is taken as the medium plateau voltage value, and the maximum voltage value of the first actual voltage value and the second actual voltage value is taken as the high plateau voltage value. For example, if the first actual voltage value is greater than the second actual voltage value, the first actual voltage value is the high plateau voltage value, and the second actual voltage value is the medium plateau voltage value; and if the first actual voltage value is less than the second actual voltage value, the second actual voltage value is the high plateau voltage value, and the first actual voltage value is the medium plateau voltage value.

The first preset voltage range and the second preset voltage range are determined according to the voltage capacity characteristics of the battery as delivered from the factory, and are not limited thereto. An upper limit value of the second preset voltage range is a lower limit value of the first preset voltage range. For example, the second preset voltage range can be set as (0, A], and the first preset voltage range can be set as (A, B].

In some embodiments, the factory data includes the factory resistance value (denoted as R), the state-of-health value (including the SOHR value of the battery), and charging data (including the charging current of the battery). The voltage plateau regions include the low voltage plateau region and the medium voltage plateau region.

In the present disclosure, it is considered that the resistance value of the battery depends on the temperature, the current, and the SOC value. When the charging current and the temperature are determined, for example, the current rate corresponding to 1.7kw charging is 0.1C and the ambient temperature is 25°C, the resistance values in the SOC segments corresponding to the different voltage plateau regions are shown in Table 1. As shown in Table 1, the fluctuation of the resistance value of the battery is smaller in the voltage plateau region.

**Table 1**

| | | | | | | |
|---|---|---|---|---|---|---|
| low voltage plateau region SOC | 8 | 9 | 10 | 10 | 11 | 12 |
| R | 1.120 | 1.118 | 1.119 | 1.118 | 1.116 | 1.121 |
| medium voltage plateau region SOC | 28 | 34 | 41 | 47 | 54 | 60 |
| R | 1.113 | 1.114 | 1.115 | 1.114 | 1.115 | 1.113 |
| high voltage plateau region SOC | 66 | 72 | 79 | 85 | 92 | 98 |
| R | 1.112 | 1.112 | 1.112 | 1.112 | 1.112 | 1.112 |

Based on the above, in the case of only low voltage plateau region and medium voltage plateau region, the calculation of the state-of-health value of the battery includes: calculating a first direct current resistance value (denoted as DCIR1) corresponding to the low voltage plateau region of the battery according to the first open-circuit voltage value (denoted as V1), the charging current (denoted as I) and the low plateau voltage value (denoted as V2), and the calculation formula can be expressed as DCIR1= (V2-V1)/I; calculating a second direct current resistance value (denoted as DCIR2) corresponding to the medium voltage plateau region of the battery according to the second open-circuit voltage value (denoted as V3), the charging current I and the medium plateau voltage value (denoted as V4), and the calculation formula can be expressed as DCIR2= (V4-V3)/I; calculating an actual resistance value of the battery (denoted as DCIR) according to the first direct current resistance value DCIR1 and the second direct current resistance value DCIR2, and the calculation formula can be expressed as DCIR2=(DCIR1+DCIR2)/2; and calculating the SOHR value of the battery according to the factory resistance value R and the actual resistance value DCIR, and the calculation formula can be expressed as SOHR=(DCIR/R)*100%.

In some embodiments, the factory data includes the factory resistance value R, the charging data includes the charging current of the battery, and the state-of-health value includes the SOHR value of the battery. In addition, the voltage plateau regions include the medium voltage plateau region and the high voltage plateau region.

In the case of only a high voltage plateau region and a medium voltage plateau region, the calculation of the state-of-health value of the battery includes: calculating the second direct current resistance value DCIR2 corresponding to the medium voltage plateau region of the battery according to the second open-circuit voltage value V3, the charging current I and the medium plateau voltage value V4, and the calculation formula can be expressed as DCIR2= (V4-V3)/I; calculating a third direct current resistance value DCIR3 corresponding to the high voltage plateau region of the battery according to the third open-circuit voltage value (denoted as V5), the charging current I and the high plateau voltage value (denoted as V6), and the calculation formula can be expressed as DCIR3=(V6-V5)/I; calculating the actual resistance value DCIR of the battery according to the second direct current resistance value DCIR2 and the third direct current resistance value DCIR3, and the calculation formula can be expressed as DCIR2= (DCIR3+DCIR2)/2; and calculating the SOHR value of the battery according to the factory resistance value R and the actual resistance value DCIR, and the calculation formula can be expressed as SOHR= (DCIR/R)*100%.

In some embodiments, three voltage plateau regions are provided, and the first actual voltage value, the second actual voltage value and the third actual voltage value respectively corresponding to the three voltage plateau regions of the battery are acquired according to the dQ/dV-V curve. That is to say, the dQ/dV-V curve formed in the charging process has three regions where the voltage of the battery changes extremely slowly, and in each region, the acquired actual voltage values are the first actual voltage value, the second actual voltage value and the third actual voltage value respectively.

In order to specifically distinguish the plateau voltage value of which voltage plateau region the first actual voltage value, the second actual voltage value and the third actual voltage value correspond to respectively, in the present disclosure, the plateau voltage value is determined by comparing the first actual voltage value, the second actual voltage value, and the third actual voltage value.

Specifically, the minimum voltage value among the first actual voltage value, the second actual voltage value and the third actual voltage value is taken as the low plateau voltage value; the maximum voltage value among the first actual voltage value, the second actual voltage value and the third actual voltage value is taken as the high plateau voltage value; the voltage value other than the minimum voltage value and the maximum voltage value among the first actual voltage value, the second actual voltage value, and the third actual voltage value is taken as the medium plateau voltage value. For example, if the first actual voltage value < the second actual voltage value < the third actual voltage value, the first actual voltage value is the low plateau voltage value, the second actual voltage value is the medium plateau voltage value, and the third actual voltage value is the high plateau voltage value.

In some embodiments, the factory data includes the factory resistance value R, the state-of-health value includes the SOHR value of the battery, and the charging data includes the charging current of the battery. In addition, the voltage plateau regions include the low voltage plateau region, the medium voltage plateau region and the high voltage plateau region.

In the case of the low voltage plateau region, the medium voltage plateau region and the high voltage plateau region, the calculation of the state-of-health value of the battery includes: calculating the first direct current resistance value (denoted as DCIR1) corresponding to the low voltage plateau region of the battery according to the first open-circuit voltage value (denoted as V1), the charging current (denoted as I) and the low plateau voltage value (denoted as V2), and the calculation formula can be expressed as DCIR1= (V2-V1)/I; calculating the second direct current resistance value (denoted as DCIR2) corresponding to the medium voltage plateau region of the battery according to the second open-circuit voltage value (denoted as V3), the charging current I and the medium plateau voltage value (denoted as V4), and the calculation formula can be expressed as DCIR2= (V4-V3)/I; calculating the third direct current resistance value DCIR3 corresponding to the high voltage plateau region of the battery according to the third open-circuit voltage value (denoted as V5), the charging current I and the high plateau voltage value (denoted as V6), and the calculation formula can be expressed as DCIR3=(V6-V5)/I; calculating the actual resistance value DCIR of the battery according to the first direct current resistance value DCIR1, the second direct current resistance value DCIR2 and the third direct current resistance value DCIR3, and the calculation formula can be expressed as DCIR2= (DCIR1+DCIR3+DCIR2)/3; and calculating the SOHR value of the battery according to the factory resistance value R and the actual resistance value DCIR, and the calculation formula can be expressed as SOHR= (DCIR/R)*100%.

In some embodiments, the factory data includes the factory capacity value (denoted as Q_{factory}), and the state-of-health value includes the SOHC value of the battery. That the state-of-health value of the battery is calculated according to the factory data, the capacity value, the open-circuit voltage value, the charging data and/or the plateau voltage value includes: generating the second charging V-Q curve of the battery according to the charging data, as shown in FIG. 2; performing the differential processing on the second charging V-Q curve to acquire a dV/dQ-Q curve corresponding to the battery, as shown in FIG. 4; acquiring the capacity difference value (denoted as Q_{HVP}) between the capacity value at the high voltage inflection point and the capacity value at the full charging point of the battery on the dV/dQ-Q curve, and acquiring an actual capacity value of the battery according to the capacity difference value Q_{HVP} and the capacity value Q_{HVTP}. Specifically, the full charging point of the battery is the point on the dV/dQ-Q curve where the battery reaches the full charging state, at this time, the available capacity in the battery reaches its maximum capacity. However, the maximum capacity of the battery when the battery reaches the full charging state changes with the aging of the battery. In the present disclosure, by utilizing the characteristic that the capacity difference value between the capacity value corresponding to the high voltage inflection point and the capacity value corresponding to the completely discharged state (SOC=0) on the V-Q curve of the battery remains unchanged, the actual capacity value Q of the battery can be acquired by only acquiring the capacity difference value Q_{HVP} between the capacity value at the high voltage inflection point and the capacity value at the full charging point of the battery on the dV/dQ-Q curve, and calculating the sum value of the capacity difference value Q_{HVP} and the capacity value Q_{HVTP}, and the calculation formula can be expressed as Q=Q_{HVP}+Q_{HVTP}.

The SOHC value of the battery is calculated according to the actual capacity value Q and the factory capacity value Q_{factory}, and the calculation formula can be expressed as SOHC=(Q/Q_{factory})*100%.

The second aspect of the present disclosure provides a computer storage medium, storing a computer program which, when executed by a processor, implements the method for calculating the state-of-health value of the battery according to the foregoing embodiments.

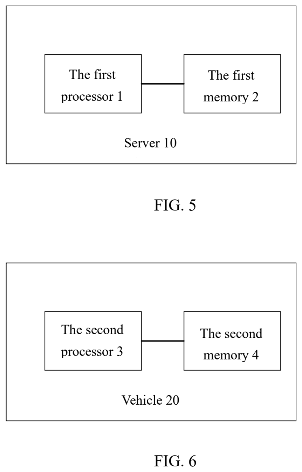

The third aspect of the present disclosure provides a server, as shown in FIG. 5, the server 10 includes at least one first processor 1 and a first memory 2 communicatively connected with the at least one first processor 1.

The first memory 2 stores a computer program executable by the at least one first processor 1, and when executing the computer program, the at least one first processor 1 implements the method for calculating the state-of-health value of the battery according to the foregoing embodiments.

That is to say, the method for calculating the state-of-health value of the battery provided by the foregoing embodiments can be implemented by the server. Specifically, before the battery is delivered from a factory, the related data of the battery, such as the factory data and the OCV-SOC curve, can be uploaded to the server side. After the battery is delivered from a factory, the charging data in the charging process of the battery can be periodically uploaded to the server side, so that the server can monitor the state-of-health of the battery in the whole life cycle according to the uploaded data, the resources of the battery application side, such as a vehicle, an airplane or a ship, need not to be occupied, and the method has great technical advantages and market value.

The uploading period of the charging data to the server can be set to [1s, 30s], the server only needs to use a low-frequency sampling signal to monitor the state-of-health value of the battery, without relying on a high-frequency sampling signal.

It should be noted that the specific implementation of the server 10 in the embodiments of the present disclosure is similar to the specific implementation of the method for calculating the state-of-health value of the battery in any of the foregoing embodiments of the present disclosure, referring to the description of the method section for details, and in order to reduce redundancy, details are not described herein again.

The server 10 according to the embodiments of the present disclosure can realize the monitoring of the state-of-health of the battery in the whole life cycle and improve the calculation accuracy of the state-of-health of the battery by implementing the method for calculating the state-of-health value of the battery provided in the embodiments.

The fourth aspect of the present disclosure provides a vehicle, as shown in FIG. 6, the vehicle 20 includes at least one second processor 3 and a second memory 4 communicatively connected with the at least one second processor 3.

The second memory 4 stores a computer program executable by the at least one second processor 3, and when executing the computer program, the at least one second processor 3 implements the method for calculating the state-of-health value of the battery according to the foregoing embodiments.

It should be noted that the specific implementation of the vehicle 20 in the embodiments of the present disclosure is similar to the specific implementation of the method for calculating the state-of-health value of the battery in any of the foregoing embodiments of the present disclosure, referring to the description of the method section for details, and in order to reduce redundancy, details are not described herein again.

The vehicle 20 according to the embodiments of the present disclosure can realize the monitoring of the state-of-health of the battery in the whole life cycle and improve the calculation accuracy of the state-of-health of the battery by implementing the method for calculating the state-of-health value of the battery provided in the embodiments.

In the description of the specification, any process or method descriptions in the flowcharts or described in any other manner can be understood as representing modules, segments, or portions of code which include one or more executable instructions for implementing specific logical functions or steps in the process, and the preferred embodiments of the present disclosure includes additional implementations which may not be in the order shown or discussed, but may include executing functions in a substantially simultaneous manner or in reverse order according to the functions involved, which will be understood by a person skilled in the art to which the embodiments of the present disclosure belong.

The logic and/or steps shown in the flowcharts or described in any other manner herein, for example, a sequenced list that may be considered as executable instructions used for implementing logical functions, may be specifically implemented in any computer-readable medium to be used by an instruction execution system, apparatus, or device (for example, a computer-based system, a system including a processor, or another system that can obtain an instruction from the instruction execution system, apparatus, or device and execute the instruction) or to be used by combining such instruction execution systems, apparatuses, or devices. In the context of this specification, a "computer-readable medium" may be any apparatus that can include, store, communicate, propagate, or transmit the program for use by the instruction execution system, apparatus, or device or in combination with the instruction execution system, apparatus, or device. More specific examples (a non-exhaustive list) of the computer-readable medium include the following: an electrical connection (an electronic apparatus) having one or more wires, a portable computer diskette (a magnetic apparatus), a random access memory (RAM), a read-only memory (ROM), an erasable programmable read-only memory (EPROM or a flash memory), an optical fiber apparatus, and a portable compact disk read-only memory (CDROM). In addition, the computer-readable medium can even be paper or other suitable media on which the program can be printed, because the program can be obtained electronically by, for example, optically scanning paper or other media, then editing, interpreting, or processing in other suitable ways if necessary, and then storing it in a computer memory.

It will be understood that, parts of the present disclosure can be implemented by using hardware, software, firmware, or a combination thereof. In the foregoing implementations, multiple steps or methods may be implemented by using software or firmware that are stored in a memory and are executed by a proper instruction execution system. For example, if hardware is used for implementation, same as in another implementation, implementation may be performed by any one of the following technologies well known in the art or a combination thereof: a discrete logic circuit including a logic gate circuit for implementing a logic function of a data signal, a dedicated integrated circuit including a proper combined logic gate circuit, a programmable gate array (PGA), a field programmable gate array (FPGA), and the like.

A person skilled in the art can understand that all or part of the steps of the method of the above embodiments can be completed by a program instructing related hardware, and the program can be stored in a computer readable storage medium, and when executed, the program includes one of the steps of the method embodiments or a combination thereof.

In addition, each functional unit in each of the embodiments of the present disclosure can be integrated into one processing module, or each unit can be physically present separately, or two or more units can be integrated into one module. The integrated module can be implemented in the form of hardware, or in the form of a software function module. If the integrated module is implemented in the form of a software function module and sold or used as a standalone product, the integrated module can also be stored in a computer-readable storage medium.

The storage medium mentioned above can be a read-only memory, a magnetic disk or an optical disk, etc. Although the embodiments of the present disclosure have been shown and described above, it will be understood that the above embodiments are exemplary and should not be construed as a limitation of the present disclosure, and a person skilled in the art can make changes, modifications, replacements and variations to the foregoing embodiments within the scope of the present disclosure.

In the description of this specification, the description of the reference terms "an embodiment", "some embodiments", "an example", "a specific example", "some examples", and the like means that specific features, structures, materials or characteristics described in combination with the embodiment(s) or example(s) are included in at least one embodiment or example of the present disclosure. In this specification, exemplary descriptions of the foregoing terms do not necessarily refer to the same embodiment or example.

Although the embodiments of the present disclosure have been shown and described above, a person skilled in the art can understand that various changes, modifications, replacements, or variations can be made to the foregoing embodiments without departing from the principles and purposes of the present disclosure. The scope of the present disclosure is limited by the claims and their equivalents.

## Claims

1. A method for calculating a state-of-health value of a battery, comprising:
(S1) acquiring factory data of a battery as delivered from a factory, and acquiring a capacity value corresponding to a high voltage inflection point of a first charging V-Q curve of the battery as delivered from the factory;
(S2) acquiring an open-circuit voltage value corresponding to a voltage plateau region of an OCV-SOC curve corresponding to the battery;
(S3) acquiring charging data of the battery in an actual charging process after delivery from the factory;
(S4) determining a plateau voltage value corresponding to the voltage plateau region of the battery according to the charging data; and
(S5) calculating the state-of-health value of the battery according to the factory data, the capacity value, the open-circuit voltage value, the charging data and/or the plateau voltage value.

2. The method for calculating a state-of-health value of a battery according to claim **1,** wherein (S2) acquiring the open-circuit voltage value corresponding to the voltage plateau region of the OCV-SOC curve corresponding to the battery comprises:
acquiring a first open-circuit voltage value corresponding to a low voltage plateau region of the OCV-SOC curve corresponding to the battery;
acquiring a second open-circuit voltage value corresponding to a medium voltage plateau region of the OCV-SOC curve corresponding to the battery; and
acquiring a third open-circuit voltage value corresponding to a high voltage plateau region of the OCV-SOC curve corresponding to the battery.

3. The method for calculating a state-of-health value of a battery according to claim 2, wherein at least two voltage plateau regions are provided, and the plateau voltage values comprise at least two of a low plateau voltage value, a medium plateau voltage value and a high plateau voltage value, and (S4) determining the plateau voltage value corresponding to the voltage plateau region of the battery according to the charging data comprises:
generating a second charging V-Q curve of the battery according to the charging data;
performing a differential processing on the second charging V-Q curve to acquire a dQ/dV-V curve corresponding to the battery;
acquiring an actual voltage value corresponding to each voltage plateau region of the battery according to the dQ/dV-V curve; and
determining the low plateau voltage value, the medium plateau voltage value and/or the high plateau voltage value of the battery according to the actual voltage value corresponding to each voltage plateau region.

4. The method for calculating a state-of-health value of a battery according to claim 3, wherein two voltage plateau regions are provided,
acquiring the actual voltage value corresponding to each voltage plateau region of the battery according to the dQ/dV-V curve comprises:
acquiring a first actual voltage value and a second actual voltage value respectively corresponding to the two voltage plateau regions of the battery according to the dQ/dV-V curve;
determining the low plateau voltage value, the medium plateau voltage value and/or the high plateau voltage value of the battery according to the actual voltage value corresponding to each voltage plateau region comprises:
calculating a voltage difference value between the first actual voltage value and the second actual voltage value;
if it is determined that the voltage difference value is in a first preset voltage range, taking the minimum voltage value of the first actual voltage value and the second actual voltage value as the low plateau voltage value, and taking the maximum voltage value of the first actual voltage value and the second actual voltage value as the medium plateau voltage value;
if it is determined that the voltage difference value is in a second preset voltage range, taking the minimum voltage value of the first actual voltage value and the second actual voltage value as the medium plateau voltage value, and taking the maximum voltage value of the first actual voltage value and the second actual voltage value as the high plateau voltage value;
an upper limit value of the second preset voltage range being a lower limit value of the first preset voltage range.

5. The method for calculating a state-of-health value of a battery according to claim 3 or 4, wherein the factory data comprises a factory resistance value, the state-of-health value comprises an SOHR value of the battery, the voltage plateau regions comprise the low voltage plateau region and the medium voltage plateau region, the charging data comprises a charging current of the battery, and (S5) calculating the state-of-health value of the battery according to the factory data, the capacity value, the open-circuit voltage value, the charging data and/or the plateau voltage value comprises:
calculating a first direct current resistance value corresponding to the low voltage plateau region of the battery according to the first open-circuit voltage value, the charging current and the low plateau voltage value;
calculating a second direct current resistance value corresponding to the medium voltage plateau region of the battery according to the second open-circuit voltage value, the charging current and the medium plateau voltage value;
calculating an actual resistance value of the battery according to the first direct current resistance value and the second direct current resistance value; and
calculating the SOHR value of the battery according to the factory resistance value and the actual resistance value.

6. The method for calculating a state-of-health value of a battery according to claim 3 or 4, wherein the factory data comprises the factory resistance value, the state-of-health value comprises the SOHR value of the battery, the voltage plateau regions comprise the medium voltage plateau region and the high voltage plateau region, the charging data comprises the charging current of the battery, and (S5) calculating the state-of-health value of the battery according to the factory data, the capacity value, the open-circuit voltage value, the charging data and/or the plateau voltage value comprises:
calculating the second direct current resistance value corresponding to the medium voltage plateau region of the battery according to the second open-circuit voltage value, the charging current and the medium plateau voltage value;
calculating a third direct current resistance value corresponding to the high voltage plateau region of the battery according to the third open-circuit voltage value, the charging current and the high plateau voltage value;
calculating the actual resistance value of the battery according to the second direct current resistance value and the third direct current resistance value; and
calculating the SOHR value of the battery according to the factory resistance value and the actual resistance value.

7. The method for calculating a state-of-health value of a battery according to claim 3, wherein three voltage plateau regions are provided,
acquiring the actual voltage value corresponding to each voltage plateau region of the battery according to the dQ/dV-V curve comprises:
acquiring a first actual voltage value, a second actual voltage value and a third actual voltage value respectively corresponding to the three voltage plateau regions of the battery according to the dQ/dV-V curve;
determining the low plateau voltage value, the medium plateau voltage value and/or the high plateau voltage value of the battery according to the actual voltage value corresponding to each voltage plateau region comprises:
taking the minimum voltage value among the first actual voltage value, the second actual voltage value and the third actual voltage value as the low plateau voltage value;
taking the maximum voltage value among the first actual voltage value, the second actual voltage value and the third actual voltage value as the high plateau voltage value;
taking the voltage value other than the minimum voltage value and the maximum voltage value among the first actual voltage value, the second actual voltage value, and the third actual voltage value as the medium plateau voltage value.

8. The method for calculating a state-of-health value of a battery according to claim 3 or 7, wherein the factory data comprises the factory resistance value, the state-of-health value comprises the SOHR value of the battery, the voltage plateau regions comprise the low voltage plateau region, the medium voltage plateau region and the high voltage plateau region, the charging data comprises the charging current of the battery, and (S5) calculating the state-of-health value of the battery according to the factory data, the capacity value, the open-circuit voltage value, the charging data and/or the plateau voltage value comprises:
calculating a first direct current resistance value corresponding to the low voltage plateau region of the battery according to the first open-circuit voltage value, the charging current and the low plateau voltage value;
calculating a second direct current resistance value corresponding to the medium voltage plateau region of the battery according to the second open-circuit voltage value, the charging current and the medium plateau voltage value;
calculating a third direct current resistance value corresponding to the high voltage plateau region of the battery according to the third open-circuit voltage value, the charging current and the high plateau voltage value;
calculating an actual resistance value of the battery according to the first direct current resistance value, the second direct current resistance value and the third direct current resistance value; and
calculating the SOHR value of the battery according to the factory resistance value and the actual resistance value.

9. The method for calculating a state-of-health value of a battery according to any of claims 3 to 8, before performing the differential processing on the second charging V-Q curve, further comprising:
performing a smoothing filtering processing on the second charging V-Q curve.

10. The method for calculating a state-of-health value of a battery according to claim 1, wherein the factory data comprises a factory capacity value, the state-of-health value comprises an SOHC value of the battery, and the (S5) calculating the state-of-health value of the battery according to the factory data, the capacity value, the open-circuit voltage value, the charging data and/or the plateau voltage value comprises:
generating a second charging V-Q curve of the battery according to the charging data;
performing a differential processing on the second charging V-Q curve to acquire a dV/dQ-Q curve corresponding to the battery;
acquiring a capacity difference value between a capacity value at a high voltage inflection point and a capacity value at a full charging point of the battery on the dV/dQ-Q curve;
acquiring an actual capacity value of the battery according to the capacity difference value and the capacity value; and
calculating an SOHC value of the battery according to the actual capacity value and the factory capacity value.

11. The method for calculating a state-of-health value of a battery according to any one of claims 1 to 10, wherein (S1) acquiring factory data of a battery as delivered from a factory comprises:
acquiring an ambient temperature of the battery; and
determining the factory data of the battery according to the ambient temperature.

12. A computer storage medium, storing a computer program which, when executed by a processor, causes the processor to implement the method for calculating a state-of-health value of a battery according to any one of claims 1 to 11.

13. A server (10) comprising:
at least one first processor (1); and
a first memory (2) communicatively connected with the at least one first processor (1),
the first memory (2) storing a computer program executable by the at least one first processor (1), and when executing the computer program, the at least one first processor (1) implementing the method for calculating a state-of-health value of a battery according to any one of claims 1 to **11.**

14. The server (10) according to claim 13, wherein the server (10) periodically receives the charging data in the charging process of the battery.

15. A vehicle (20) comprising:
at least one second processor (3);
a second memory (4) communicatively connected with the at least one second processor (3),
the second memory (4) storing a computer program executable by the at least one second processor (3), and when executing the computer program, the at least one second processor (3) implementing the method for calculating a state-of-health value of a battery according to any one of claims 1 to 11.
